Europäisches Patentamt

(19) European Patent Office (11) Veröffentlichungsnummer: **0 008 642**
**B1**
Office européen des brevets

(12) **EUROPÄISCHE PATENTSCHRIFT**

(45) Veröffentlichungstag der Patentschrift: (51) Int. Cl.³: **H 01 L 21/223,** H 01 L 21/316,
28.07.82 C 30 B 31/02

(21) Anmeldenummer: 79102455.7

(22) Anmeldetag: 16.07.79

(54) **Verfahren zum Dotieren von Siliciumkörpern mit Bor.**

(30) Priorität: 07.09.78 DE 2838928

(43) Veröffentlichungstag der Anmeldung:
19.03.80 Patentblatt 80/6

(45) Bekanntmachung des Hinweises auf die Patenterteilung:
28.07.82 Patentblatt 82/30

(84) Benannte Vertragsstaaten:
DE FR GB

(56) Entgegenhaltungen:
DE-A-1 489 240
FR-A-1 551 367
FR-A-2 092 728

IEM JOURNAL OF RESEARCH & DEVELOPMENT, vol.
18, Januar 1974, New York, USA. R.F. Lever und H.M.
Demsky: «Water vapor as an oxidant in BBr₃ open-tube
silicon diffusions systems», Seiten 40–46

(73) Patentinhaber: **International Business Machines
Corporation, Armonk, N.Y. 10504 (US)**

(72) Erfinder: **Briska, Marian, Nürtinger Strasse 51,
D-7030 Böblingen (DE)**
Erfinder: **Thiel, Klaus Peter, Reiherweg 2,
D-7030 Böblingen (DE)**

(74) Vertreter: **Oechssler, Dietrich, Dr.rer.nat. Dipl.-Chem.,
Schönaicher Strasse 220, D-7030 Böblingen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Verfahren zum Dotieren von Siliciumkörpern mit Bor

Die Erfindung betrifft ein Verfahren zum Dotieren von Siliciumkörpern durch Eindiffundieren von Bor, bei dem in einem ersten Wärmeprozess eine die höchstens teilweise maskierte Oberfläche der Siliciumkörper bedeckende Borglasschicht und unter dieser in den nicht maskierten Bereichen eine $SiB_6$-Schicht erzeugt werden, indem die Siliciumkörper einem eine festgelegte Bormenge und Bor und Sauerstoff in einem festgelegten Mengenverhältnis enthaltenden Gasgemisch ausgesetzt werden, bei dem vor einem zweiten Wärmeprozess das Borglas vollständig abgelöst wird, ohne dass dabei die $SB_6$-Schicht wesentlich angegriffen wird, und bei dem in dem zweiten Wärmeprozess Bor in das Silicium hineingetrieben wird. Ein derartiges Verfahren ist aus der Zeitschrift Journal of the Electrochemical Society, Bd. 115, März 1968, S. 291–294 bekannt.

Zum Eindiffundieren von Bor in Silicium sind Kapseldiffusionsverfahren und Verfahren bekannt, bei welchen die Siliciumkörper einem durch das Reaktionsrohr strömenden Gasstrom, welcher eine Borquelle enthält, ausgesetzt wird. Bei der Kapseldiffusion lassen sich sehr homogene und reproduzierbare Ergebnisse erzielen. Nachteilig an der Kapseldiffusion ist jedoch, dass der Material- und apparative Aufwand sehr hoch ist. Es wird beispielsweise bei jeder Charge eine teure Quarzkapsel verbraucht, und es werden ein Hochvakuumpumpstand und dazugehörige Ausheizöfen benötigt. Hinzu kommt, dass bei der Kapseldiffusion relativ viel manuelle Arbeit betätigt ist, so dass das Verfahren sich schlecht dazu eignet, in eine automatische Fertigungslinie eingebaut zu werden. Nachteilig ist die Kapseldiffusion auch bei solchen Diffusionen, beispielsweise bei der Basisdiffusion für einen Bipolartransistor, bei welchen im Anschluss an die Diffusion ein bei der nachfolgenden Diffusion für Maskierungszwecke benötigtes Oxid aufgewachsen werden muss. Die Bordiffusionen mittels eines eine Borquelle enthaltenden Gasstromes, welcher an den Siliciumkörpern vorbeiströmt (im folgenden «offene Diffusion» genannt), sind demgegenüber, sowohl apparativ als auch was das benötigte Material betrifft, wesentlich weniger aufwendig. So muss das Bedienungspersonal bei ihnen sehr wenig eingreifen, so dass sich diese Art Diffusion gut für eine automatische Fertigungslinie eignet. Bei den üblichsten offenen Diffusionen wird auf der Oberfläche des Siliciumkörpers, welcher mit Bor dotiert werden soll, ein Borglas erzeugt, indem die hocherhitzten Siliciumkörper einem oxidiertes Bor enthaltenden Gasstrom ausgesetzt werden. Das oxidierte Bor gelangt in den Gasstrom, indem dieser an hocherhitzten, mit $B_2O_3$ überzogenen Bornitrid-Plättchen vorbeigeleitet oder indem im Gasstrom enthaltener Sauerstoff mit einem (bei Raumtemperatur) flüssigen oder gasförmigen, Bor enthaltenden Material zur Reaktion gebracht wird. Eine offene Diffusion, bei welcher als Borquelle bevorzugt mit $B_2O_3$ überzogenes Bornitrid verwendet wird, ist beispielsweise in der Deutschen Offenlegungsschrift 2 316 520 beschrieben. Offene Diffusionen, bei denen das bei Raumtemperatur flüssige Borbromid ($BBr_3$) als Borquelle verwendet wird, sind in der US-Patentschrift 3 676 231 und in den Artikeln «The Influence of the Reaction Kinetics of $O_2$ and Source Flow Rates on the Uniformity of Boron and Arsenic Diffusions» in der Zeitschrift «Solid State Electronics», 1971, Band 14, Seiten 281ff. und «The Influence of Reaction Kinetics Between $BBr_3$ and $O_2$ on the Uniformity of Base Diffusion» in der Zeitschrift «Proceedings of the IEEE», Band 57, Nr. 9, Sept. 1969, Seiten 1507ff. von P.C. Parekh und D.R. Goldstein beschrieben. Die Beschreibung einer offenen Bor-Diffusion unter Verwendung des bei Zimmertemperatur gasförmigen $B_2H_6$ als Borquelle findet sich beispielsweise in dem Artikel «Ellipsometric Investigation of Boron-Rich Layers on Silicon» von K.M. Busen u.a. im «Journal of the Electrochemical Society», Band 115, März 1968, Seiten 291ff.

Wenn das $B:O_2$-Mengenverhältnis nicht zu klein gewählt wird, so bildet sich, wie sich aus dem obenerwähnten Artikel von K.M. Busen ergibt, unter dem direkt auf dem Silicium aufliegenden Borglas eine siliziumreiche Borphase $SiB_6$). Wie sich aus dem obenerwähnten Artikel von K.M. Busen u.a. ergibt, ist die Bildung der $SiB_6$-Phase für eine gut kontrollierte Bordiffusion vorteilhaft, wobei dieser günstige Effekt jedoch nur eintritt, wenn die $SiB_6$-Phase vor dem Boreintreiben im zweiten Wärmeprozess entfernt wird. Busen u.a. empfehlen zur Entfernung der $SiB_6$-Phase entweder ein Ätzmittel, welches auch Silicium ätzt, oder einen Zweischrittprozess zu verwenden, bei dem im ersten Schritt die Phase zehn Minuten lang in kochender konzentrierter Salpetersäure und anschliessend 30 Sekunden lang in verdünnter HF behandelt wird. Die Verwendung von Siliciumätzmitteln ist ungünstig, wenn Siliciumplättchen prozessiert werden, auf welchen integrierte Schaltungen entstehen sollen, und der Zweistufenprozess muss, wie sich aus dem Artikel ergibt, möglicherweise mehrfach angewandt werden, damit die $SiB_6$-Phase vollständig entfernt wird. Aufgrund dieser Unzuverlässigkeit des Ätzprozesses ist der Zweistufenprozess für ein Fabrikationsverfahren ungeeignet. In dem Artikel «Glass Source B Diffusion in Si und $SiO_2$», welcher im «Journal of the Electrochemical Society», Band 118, Februar 1971, Seiten 293ff. veröffentlicht ist, schlagen deshalb D.M. Brown und P.R. Kennicott unter Hinweis auf den Artikel von Busen u.a. ein Bordiffusionsverfahren vor, b-- welchem die Bildung der $SiB_6$-Phase verm;__en wird. Zwangsläufig werden dabei natürlich auch die Vorteile der $SiB_6$-Phase nicht wahrgenommen. Bei dem in der deutschen Offenlegungsschrift 2 316 520 beschriebenen Verfahren werden die von K.M. Busen genannten Vorteile in der von Busen genannten Art und Weise ausgenutzt, in-

dem die SiB$_6$-Phase nach ihrer Bildung in einem Hochtemperatur-Oxidationsschritt in ein gut lösliches Oxid umgewandelt wird, welches vor dem zweiten Wärmeprozess weggelöst wird.

Trotz dieser Vorkehrungen liefert das in der Offenlegungsschrift beschriebene Verfahren bei der Herstellung von niederdotierten Diffusionsgebieten (Oberflächenwiderstände: $>300\ \Omega/\square$, Eindringtiefe: Grössenordnung 1 µm) innerhalb sehr enger Toleranzen über den Siliciumkörper und über eine ganze Charge keine homogenen und reproduzierbaren Ergebnisse. Bei dem zunehmenden Trend zu dichtgepackten, hochintegrierten Schaltungen sind die mit dem in der Offenlegungsschrift beschriebenen Verfahren erzielten Ergebnisse deshalb nicht mehr voll befriedigend. Bei der Herstellung hochdotierter Bereiche kann sich im übrigen – worauf im einzelnen noch weiter unten eingegangen wird – in bestimmten Fällen die intensive Sauerstoffbehandlung nach der Belegung mit Boroxid sehr ungünstig auswirken.

Es ist die Aufgabe der Erfindung, ein Diffusionsverfahren zum Dotieren von Silicium mit Bor bei der Erzeugung insbesondere von dichtgepackten hochintegrierten Schaltungen anzugeben, welches zeitsparend, kostengünstig, vielseitig einsetzbar, gut steuer- und überschaubar und reproduzierbar ist und sich in eine automatische Fertigungslinie integrieren lässt.

Diese Aufgabe wird durch die im kennzeichnenden Teil des Patentanspruchs 1 angegebene Verwendung des eingangs genannten Verfahrens gelöst.

Zwar sind aus dem obengenannten Artikel von K. M. Busen u. a. Versuche bekannt, bei denen vor dem Eintreiben nur das Borglas, aber nicht die siliciumreiche Phase entfernt wird. Aus den dabei erzielten Ergebnissen haben jedoch Busen u. a. den Schluss abgeleitet, dass zur Erzielung guter Diffusionsergebnisse die SiB$_6$-Phase vor dem Eintreiben entfernt werden muss, so dass diese Versuche nicht als Anregung für die Lösung der gestellten Aufgabe dienen konnten. Überraschenderweise hat sich herausgestellt, dass bei Anwendung des erfindungsgemässen Verfahrens sehr homogene (über den Siliciumkörper und über die Charge) und sehr reproduzierbare Ergebnisse innerhalb sehr enger Toleranzen, und zwar sowohl bei der Herstellung von hoch- als auch von niederohmigen Gebieten erzielt werden können. Aufgrund dieser guten Eigenschaften empfiehlt sich die Anwendung des erfindungsgemässen Verfahrens insbesondere bei der Herstellung der heute immer üblicher werdenden dichtgepackten und hochintegrierten Schaltungen. Die Vorteile des erfindungsgemässen Verfahrens lassen sich besonders gut daran ablesen, dass bei der Herstellung hochintegrierter Schaltungen unter Anwendung des erfindungsgemässen Verfahrens sowohl für die Herstellung von Basiszonen als auch bei der Herstellung von Strukturen, welche Subisolations- neben Subkollektorbereichen aufweisen, die Anzahl der Emitterkollektorkurzschlüsse in bipolaren Transistoren wesentlich kleiner ist als bei der Herstellung von Schaltungen geringerer Integrationsdichte unter Anwendung bekannter Verfahren.

Es ist vorteilhaft, wenn das O$_2$:B-Verhältnis und die pro Zeiteinheit dem Gasgemisch zugefügte Borquellenmenge so festgelegt wird, dass ein Borglas entsteht, welches in gepufferter Flusssäure nur unvollständig, jedoch durch eine Behandlung in Flusssäure, dann in heisser Salpetersäure und schliesslich noch einmal in Flusssäure ohne Rückstand entfernt wird. Es hat sich dabei als günstig erwiesen, wenn die Siliciumkörper zehn Sekunden in eine im Verhältnis 1:10 mit Wasser verdünnte Flusssäure, dann zehn Minuten in auf 95 °C erhitzte, konzentrierte Salpetersäure und schliesslich 30 Sekunden lang in Flusssäure 1:10) getaucht werden. Bei diesem Ätzvorgang wird Silicium nicht angegriffen, was besonders wichtig beim Behandeln von Siliciumkörpern ist, auf bzw. in denen integrierte Schaltungen entstehen. Ausserdem wird bei dem Ätzverfahren das Borsilicatglas – ohne dass die SiB$_6$-Phase wesentlich angegriffen wird – zuverlässig weggelöst, so dass sich das Verfahren sehr gut für eine fabrikmässige Fertigung eignet. Bemerkenswert sind auch die ausserordentlich gut reproduzierbaren Ergebnisse, die bei Anwenden dieses Ätzverfahrens erhalten werden.

Es ist vorteilhaft, wenn als Borquelle BBr$_3$ verwendet wird und die Siliciumplättchen einem bei der Belegungstemperatur aus BBr$_3$ und O$_2$ entstandenen und in einem strömenden Trägergas enthaltenen Gemisch ausgesetzt werden. Es ist dabei günstig, wenn beim ersten Wärmeprozess unter Zugrundelegung eines inneren Durchmessers des Reaktionsrohrs von ungefähr 8 cm mit einem Trägergasfluss im Bereich zwischen 2 und 5 Liter/Minute und einem Stabilisierungsgasfluss im Bereich zwischen 0,5 und 1 Liter/Minute gearbeitet wird und wenn dem Trägergas während des Belegens BBr$_3$-Mengen im Bereich zwischen etwa 15 und etwa 30 Milligramm/Minute und mindestens während des Belegens eine derart auf die BBr$_3$-Menge abgestimmte Sauerstoffmenge zugefügt werden, dass das O$_2$:BBr$_3$-Molverhältnis im Bereich zwischen etwa 20 und etwa 65 liegt. Wird mit einem Reaktionsrohr mit einem Innendurchmesser von ungefähr 11 cm gearbeitet, so liegt der günstige Trägergasfluss im Bereich zwischen 3,5 und 8,5 Liter/Minute und die günstige BBr$_3$-Menge im Bereich zwischen etwa 18 und etwa 36 Milligramm/Minute.

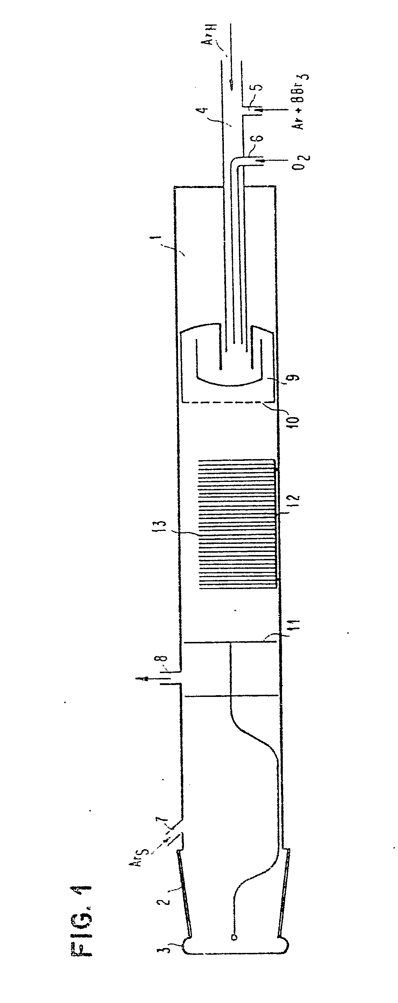

Es ist vorteilhaft, wenn während des ersten Wärmeprozesses die in einem Boot senkrecht zum Gasstrom angeordneten und in der Form von Siliciumplättchen vorliegenden Siliciumkörper in eine ein flaches Temperaturprofil aufweisende Reaktionszone gestellt werden, in welche das aus einer Mischkammer kommende Gasgemisch durch eine etwa den Rohrquerschnitt ausfüllende, senkrecht zur Rohrachse stehende Lochplatte geleitet wird und welche durch die Lochplatte und durch eine aus zwei zur Rohrachse senkrecht stehende Quarzscheiben bestehende Schikane begrenzt wird, wobei das Gasgemisch zwischen den Quarzscheiben durch eine Rohrleitung abgesaugt und zwischen der Schikane und dem mit einer Schliffkappe verschlossenen Rohrende Stabilisierungsgas eingeleitet wird (siehe Seite 18 und Fig. 1). Durch diese Ausgestaltung des Reaktionsrohres und diese Gasführung wird eine Reaktionszone definiert, in der alle im Boot stehenden Siliciumplättchen den gleichen Bedingungen ausgesetzt sind. Eine zusätzliche Vereinheitlichung der Reaktionsbedingungen lässt sich noch dadurch erreichen, dass die Reaktionszone, wenn keine Charge sich im Rohr befindet bzw. nicht vordotiert wird, ständig auf der Belegungstemperatur gehalten und das Rohr mit Sauerstoff gespült wird und dass, wenn während einer festgelegten Zeit keine Charge im Rohr prozessiert wurde, das Rohr vor der erneuten Benutzung eine festgelegte Zeit lang durch Einleiten des während der Belegung fliessenden Gasgemisches bei der Belegungstemperatur vordotiert wird. Es wird dadurch erreicht, dass alle die Reaktionszone umgebenden Teile des Rohrs mit einer Borglasschicht bedeckt sind, welche sich während des Prozessierens einer Charge im Gleichgewicht mit dem Reaktionsgas befindet, wodurch die Homogenität der Verhältnisse entlang der Reaktionszone, denen die Siliciumplättchen ausgesetzt sind, noch verbessert wird.

Zur Erzeugung von dotierten Gebieten, welche nach dem zweiten Wärmeprozess bei Eindringtiefen (xj) im Bereich zwischen etwa 0,5 und etwa 1 µm Schichtwiderstände Rs) im Bereich zwischen etwa 300 und 700 $\Omega/\square$ aufweisen, ist es vorteilhaft, wenn beim ersten Wärmeprozess bei einer Temperatur im Bereich zwischen etwa 850 und 950 °C gearbeitet und ein $O_2$:$BBr_3$-Molverhältnis im Bereich zwischen etwa 20 und etwa 65 eingestellt wird, wobei bei einer Gesamtstrommenge von ungefähr 3,5 Liter/Minute zwischen etwa 15 und 30 Milligramm $BBr_3$ pro Minute zugesetzt werden, und wenn der zweite Wärmeprozess in einer oxidierenden Atmosphäre durchgeführt wird. Man erhält dabei beim ersten Wärmeprozess ein bezüglich seiner Dicke und seiner Ätzbarkeit sehr homogenes Borglas. Diese Besonderheiten des erfindungsgemässen Verfahrens tragen u.a. dazu bei, dass sich mit dieser Ausgestaltung des erfindungsgemässen Verfahrens eine bei so niedrig mit Bor dotierten Gebieten bisher unerreichte Homogenität und Reproduzierbarkeit der Ergebnisse [±5 Prozent nach dem dritten Wärmeprozess (siehe Tabelle I)], und zwar nicht nur über die einzelnen Siliciumplättchen, sondern über die ganzen Chargen erreichen lässt, weshalb das Verfahren insbesondere dann sehr vorteilhaft ist, wenn sehr enggefasste Fertigungsspezifikationen eingehalten werden müssen. Diese Ausgestaltung des erfindungsgemässen Verfahrens eignet sich sehr gut, um Basiszonen bipolarer Transistoren in hochintegrierten und dichtgepackten Schaltungen zu erzeugen. Es ist dabei möglich, bei sehr kleinen Basisweiten enge Toleranzen einzuhalten, so dass Emitter-Kollektorkurzschlüsse weitgehend vermieden werden können. In vorteilhafter Weise kann ein dotiertes Gebiet mit einer Eindringtiefe von ungefähr 0,75 µm und einem Oberflächenwiderstand Rs von 400 ± 20 $\Omega/\square$ (nach dem dritten Wärmeprozess) erzeugt werden, indem über die in einem Reaktionsrohr mit ungefähr 8 cm innerem Durchmesser stehenden Siliciumplättchen bei einer Temperatur von 875 ± 1 °C zunächst 15 Minuten lang ein aus 3,2 Liter Argon pro Minute und 0,08 Liter Sauerstoff pro Minute bestehendes Gasgemisch, dann 20 Minuten lang dieses Gasgemisch, dem zusätzlich 0,08 Liter Argon pro Minute, welches zuvor bei einer Temperatur von 5 °C mit Borbromid gesättigt worden war, und schliesslich noch einmal 15 Minuten lang das zuerst verwendete Gasgemisch geleitet wird und indem nach dem Abkühlen die Borglasschicht abgelöst wird und anschliessend bei 925 ± 1 °C über die Siliciumplättchen zunächst zehn Minuten lang 1,5 Liter Sauerstoff pro Minute, dann 51 Minuten lang Wasserdampf und schliesslich noch einmal zehn Minuten lang 1,5 Liter $O_2$ pro Minute geleitet werden, wobei ungefähr 0,200 µm Siliciumdioxid aufwachsen.

Zur Erzeugung von niederohmigen Dotierungsgebieten ist es vorteilhaft, wenn im ersten Wärmeprozess das zum Dotieren notwendige Bor bei Temperaturen im Bereich zwischen etwa 900 und etwa 1000 °C unter Einwirkung von möglichst wenig Sauerstoff in das Silicium eingebracht wird und wenn im zweiten Wärmeprozess in einer inerten Gasatmosphäre gearbeitet wird. In vorteilhafter Weise lässt sich der am Verfahren beteiligte Sauerstoff dadurch auf ein Minimum reduzieren, dass beim ersten Wärmeprozess die Siliciumplättchen nur kurz einem sowohl Sauerstoff als auch die Borquelle enthaltenden Gasgemisch und während der übrigen Zeit nur einem Argonstrom ausgesetzt werden. Die angesprochene Ausgestaltung des erfindungsgemässen Verfahrens ist vorteilhaft zur Herstellung von Isolations- und insbesondere von Subisolationsbereichen. Gerade bei der Herstellung von Subisolationsbereichen ist es vorteilhaft, wenn auf eine Reoxidation verzichtet werden kann, weil anschliessend sowieso das ganze Oxid abgelöst wird, damit eine Epitaxieschicht auf das Substrat aufgewachsen werden kann. Günstig für die Epitaxie ist dabei, dass nach dem Ablösen des Borglases optisch sehr blanke Oberflächen erhalten werden. Ausserdem ist die laterale Ausdiffusion aus den bei der Subisolationsdiffusion entstandenen Bereichen in die Epitaxieschicht hinein bei Anwendung des erfindungsgemässen Verfahrens geringer als bei Anwendung irgendeines bekannten Diffusionsverfahrens. Hinzu kommt, dass das Verfahren zeitsparend und kostengünstig ist. Bei der Herstellung von niederohmigen Dotierungsgebieten ist zwar die Homogenität und die Reproduzierbarkeit der Ergebnisse kein solches Problem wie bei den hochohmigen Dotierungsgebieten, trotzdem soll nicht unerwähnt bleiben, dass das erfindungsgemässe Verfahren auch bei niederohmigen Dotierungsgebieten ausserordentlich homogene und sehr gut reproduzierbare Ergebnisse liefert. Zur Erzeugung eines dotierten Bereichs mit einer Eindringtiefe von 0,8 µm und einem Oberflächen-

widerstand $R_s$ von 32 $\Omega/\square$ ist es vorteilhaft, wenn die Siliciumplättchen in einer Argonatmosphäre innerhalb von etwa 22 Minuten von etwa 900 auf 970 °C erhitzt werden, anschliessend bei 970 °C vier Minuten lang einem fliessenden Gasgemisch von 3,6 Liter Argon, 0,1 Liter Sauerstoff und 0,1 Liter Argon, welches zuvor bei einer Temperatur von +5 °C mit $BBr_3$ gesättigt worden war, und daraufhin fünf Minuten lang einem Argonstrom von 1,5 Liter pro Minute ausgesetzt werden, dann innerhalb 20 Minuten unter Aufrechterhaltung des Argonstroms von 970 auf etwa 900 °C abgekühlt werden, wenn nach dem Entnehmen aus dem Ofen das Borglas vollständig abgelöst und schliesslich die Siliciumplättchen 80 Minuten lang bei 1000 °C in einer Stickstoff- oder Argonatmosphäre behandelt werden.

Eine praktische Anwendung findet diese Ausgestaltung des erfindungsgemässen Verfahrens bei der Herstellung von Strukturen, in welchen Bordotierte Subisolationsgebiete nahe bei Arsen-dotierten Subkollektorgebieten gelegen sind. Soll eine Überlappung dieser Bereiche vermieden werden, so müssen Subisolations- und Subkollektorbereiche einen ausreichenden Abstand voneinander haben. Derartige Vorkehrungen erfordern viel Platz, was dem zunehmenden Trend in der Halbleitertechnik zu höheren Packungsdichten und hochintegrierten Schaltungen zuwiderläuft. Bisher musste jedoch eine Überlappung zumindestens dann in jedem Fall vermieden werden, wenn die Subisolationsbereiche mittels einer offenen Diffusion erzeugt werden sollten. Dies war deshalb notwendig, weil in den Überlappungsgebieten sich Versetzungen im Siliciumkristall bildeten. Versetzungen sind Störungen im einkristallinen Material. Im Bereich dieser Störungen, welche ausserdem die Tendenz haben, sich im Kristall auszubreiten, diffundieren die Dotierungsverunreinigungen wesentlich rascher als in den nichtgestörten Kristallbereichen, weshalb Versetzungen eine häufige Ursache von Kollektor-Emitter-Kurzschlüssen bei bipolaren Transistoren sind. Ausserdem verursachen Versetzungen erhebliche Mengen von Kollektor-Isolationsdurchbrüchen. G. Schorer und E. Biedermann haben die Versetzungen in As/Bor-Überlappungsgebieten genauer untersucht und ihre Ergebnisse in dem Artikel «Generation of Dislocations in As/B Double-diffused Areas in Silicon» (s. Abstracts der auf der ESSDERC 77, Brighton 1977, gehaltenen Vorträge, Seiten 14ff.) beschrieben. Für ihre Untersuchungen benutzten die Autoren Siliciumplättchen, welche zunächst einer Arsendiffusion und anschliessend einer offenen Bordiffusion, bei welcher in bekannter Weise in einem ersten Wärmeprozess die Belegung mit Bor erfolgt und dann in einem zweiten Wärmeprozess – ohne dass das Borglas zuvor abgelöst wird – das Bor in einer oxidierenden Atmosphäre weiter in das Silicium hineingetrieben wurde, ausgesetzt worden waren. Die Autoren fanden Versetzungen und konnten feststellen, dass tatsächlich zwei Arten von Versetzungen vorlagen, welche sie als «60°» und «90°-Versetzungen» bezeichneten. Die Autoren konnten ausserdem feststellen, dass die «90°-Versetzungen» sich beim oxidierenden Eintreiben bilden, während die «60°-Versetzungen» bereits nach dem ersten Wärmeprozess vorhanden sind. Da gefunden wurde, dass die Versetzungen nur in den Siliciumgebieten auftreten, welche sowohl der Arsen- als auch der Bordiffusion ausgesetzt worden waren, wurde vermutet, dass das gleichzeitige Vorhandensein einer hohen Bor- und einer Arsenkonzentration die Bildung der Versetzungen begünstigt. Überraschenderweise wurde nun gefunden, dass bei Anwendung des erfindungsgemässen Verfahrens weder die «60-» noch die «90°-Versetzungen» auftreten. Dies ist auch deshalb überraschend, weil bei Anwendung des erfindungsgemässen Verfahrens in den Arsen-dotierten Bereichen (Arsenoberflächenkonzentration $C_O > 10^{21}$ Arsenatome/cm³) nach der Borbelegung – infolge der $SiB_6$-Bildung – eine Boroberflächenkonzentration $C_O$ von etwa $10^{22}$ Boratomen/cm³ und nach dem Eintreiben ein $C_O$ von $7 \cdot 10^{20}$ Boratomen/cm³ gemessen wird. Diese Werte sind näher als die entsprechenden bei Anwendung bekannter Verfahren erhaltenen Werte. Durch die Anwendung des erfindungsgemässen Verfahrens ist es also nun möglich, die Spezifikationen für die Herstellung von sehr dichtgepackten Halbleiterstrukturen nicht nur in der Weise festzulegen, dass eine Überlappung von Arsen- und Bor-dotierten Gebieten in Ausnahmefällen toleriert werden kann, vielmehr können die Spezifikationen sogar so festgelegt werden, dass eine Überlappung solcher Gebiete notwendigerweise eintritt. Auf diese Weise lässt sich eine wesentlich grössere Packungsdichte als bisher möglich erreichen.

Weitere vorteilhafte Ausgestaltungen des erfindungsgemässen Verfahrens ergeben sich aus den Unteransprüchen.

Die Erfindung wird anhand von durch Zeichnungen erläuterten Ausführungsbeispielen beschrieben. Es zeigen:

Fig. 1 in schematischer Darstellung eine Ausführungsform eines Reaktionsrohres, welches bei der Durchführung des erfindungsgemässen Verfahrens benutzt werden kann,

Fig. 2 in einem Diagramm die Abhängigkeit der Oberflächenwiderstände bei einer hochohmigen Bor-Diffusion von der Borbromidmenge, welche dem über die Halbleiterplättchen fliessenden Gasgemisch zugemischt wird, für verschiedene Sauerstoff:$BBr_3$-Verhältnisse,

Fig. 3 nach dem ersten und dem zweiten Wärmeprozess gemessene Borprofile (aufgetragen gegen die Eindringtiefe) in einem Siliciumkörper, welche bei der Durchführung einer Ausführungsform des erfindungsgemässen Verfahrens entstanden, und

Fig. 4A–4E schematische Querschnitte durch eine Halbleiterstruktur in verschiedenen Stadien der Herstellung unter Anwendung des erfindungsgemässen Verfahrens.

In der folgenden Beschreibung wird durchgängig $BBr_3$ als Borquelle verwendet, wobei aber klargestellt sei, dass das erfindungsgemässe Verfahren nicht auf die Anwendung dieses Quellmaterials beschränkt ist. Als Siliciumkörper werden Siliciumplättchen in Scheibenform, wie sie im allgemeinen für die Herstellung integrierter Schaltungen eingesetzt werden, benutzt. Ganz allgemein besteht das erfindungsgemässe Verfahren aus drei Verfahrensabschnitten. Der erste Verfahrensschritt besteht aus einem ersten Wärmeprozess, bei welchem unter Bildung eines Borglases und einer siliziumreichen Phase $SiB_6$) das Siliciumplättchen mit Boroxid belegt wird. Bei diesem ersten Wärmeprozess, bei welchem es sich um eine offene Diffusion handelt, wird über die Siliciumplättchen ein Gasstrom geleitet, welcher mindestens zeitweilig Bor und Sauerstoff in irgendeiner Form enthält. Im zweiten Verfahrensabschnitt wird das gebildete Borglas abgelöst, und im dritten Verfahrensabschnitt wird das Bor mindestens teilweise in das Silicium hineingetrieben.

Für den ersten Wärmeprozess wird ein in der Halbleitertechnik üblicher Rohrofen verwendet. Diese Öfen enthalten ein zylinderförmiges Heizelement, welches das Reaktionsrohr umgibt. Die Heizung ist so ausgebildet, dass in der Mitte des Ofens über eine zwischen 30 und 60 cm lange Strecke entlang der Achse des Heizelementes eine einheitliche Temperatur mit einer Genauigkeit von ± 1 °C aufrechterhalten werden kann. Das heisst, das Temperaturprofil entlang der Heizelementachse weist in der Mitte des Ofens ein zwischen etwa 30 und 60 cm langes, flaches Stück auf. Das für die Durchführung des erfindungsgemässen Verfahrens verwendete Reaktionsrohr kann in verschiedener Weise ausgebildet sein; eine vorteilhafte Ausgestaltung zeigt die Fig. 1. Die schematische Fig. 1 ist nicht massstabsgerecht, insbesondere stimmt nicht das Höhen/Längen-Verhältnis. Das Reaktionsrohr 1 mit kreisförmigem Querschnitt hat an seinem einen Ende eine Öffnung 2, durch welche die Boote 12 mit den Siliciumplättchen 13 in das Reaktionsrohr geschoben werden. Die Öffnung 2 lässt sich mit der Schliffkappe 3 verschliessen. Durch das andere verschlossene Ende des Reaktionsrohres 1 ist etwa in der Rohrachse ein Zuleitungsrohr 4, welches konzentrisch noch ein Zuleitungsrohr 6 enthält, in das Reaktionsrohr 1 hereingeführt. In das Zuleitungsrohr 4 mündet ausserhalb des Reaktionsrohres 1 ein Zuleitungsrohr 5. Die Zuleitungsrohre 4 und 6 enden in einer Mischkammer 9, welche zur intensiven Vermischung der einströmenden Gase dient und welche auf ihrer der Öffnung 2 zugewandten Seite eine Lochplatte 10 aufweist. Die Mischkammer ist rund und hat einen Aussendurchmesser, der etwas kleiner ist als der Innendurchmesser des Reaktionsrohres 1. In das Reaktionsrohr 1 mündet in der Nähe der Öffnung 2 ein Zuleitungsrohr 7 und zwischen diesem und der Lochplatte 10 zweigt ein Ableitungsrohr 8 ab. Dort, wo das Ableitungsrohr 8 abzweigt, steht im Reaktionsrohr eine Schikane 11, welche aus zwei miteinander verbundenen runden Scheiben besteht, welche parallel zueinander, konzentrisch und senkrecht zur Rohrachse angeordnet sind und einen Durchmesser haben, welcher etwas kleiner als der Innendurchmesser des Rohrs 1 ist. Zwischen der Lochplatte 10 und der Schikane 11 befindet sich die Reaktionszone, in welcher die Siliciumplättchen 13 während des Prozessierens stehen. Dazu werden die Siliciumplättchen 13 in die Schlitze eines Bootes 12, in welchem sie senkrecht und parallel zueinander stehen, gesteckt, und dann wird das Boot 12, nachdem die Schliffklappe 3 und die Schikane 11 entfernt worden ist, durch die Öffnung 2 in die Reaktionszone des Rohres 1 geschoben, wo die Siliciumplättchen 13, deren Durchmesser ungefähr $^3/_4$ des Rohrinnendurchmessers beträgt, senkrecht zur Reaktionsrohrachse stehen. Anschliessend wird die Schikane 11 wieder an ihren Platz gebracht und die Öffnung 2 mit der Schliffkappe 3 verschlossen. Beim Entnehmen wird das Gesagte in der umgekehrten Reihenfolge wiederholt. Alle in der Fig. 1 gezeigten Teile – natürlich ausser den Siliciumplättchen – bestehen bevorzugt aus Quarz.

Die Gasversorgung und Gasentsorgung des Reaktionsrohrs 1 erfolgt in der folgenden Weise: durch das Zuleitungsrohr 4 strömt das bevorzugt aus Argon bestehende Trägergas $Ar_H$), in welches während der Belegung eine relativ kleine Menge Argon, welche $BBr_3$ enthält, durch das Zuleitungsrohr 5 ausserhalb des Reaktionsrohres eingespeist wird. Die relativ kleine Argonmenge wird mit dem $BBr_3$ beladen, indem sie durch das flüssige $BBr_3$ geleitet wird, wobei das Argon so viel $BBr_3$ aufnimmt, wie der Sättigungsmenge bei der Temperatur, auf welcher sich das $BBr_3$ befindet, entspricht. Eine bestimmte $BBr_3$-Konzentration in dem Argon wird also eingestellt, indem das $BBr_3$ auf einer festgelegten Temperatur gehalten wird. Durch das Rohr 6 wird, wenn dies erwünscht ist, Sauerstoff zugegeben. Das $BBr_3$ mischt sich mit dem Sauerstoff erst in der Mischkammer, welche sich praktisch auf derjenigen Temperatur befindet, bei welcher auch die Belegung der Siliciumplättchen mit Boroxid stattfindet. Durch das Zuleitungsrohr 7 strömt eine festgelegte Argonmenge $Ar_s$), welche dazu dient, den über die Siliciumplättchen 13 streichenden Gasstrom zu stabilisieren. Die Ableitung der in das Reaktionsrohr 1 einströmenden Gase erfolgt durch das Ableitungsrohr 8. Zum Eintreiben des Bors wird üblicherweise ein Ofen derselben Art wie beim Belegen verwendet. Das beim Eintreiben benutzte Reaktionsrohr hat ein mit einer Schliffklappe verschliessbares offenes Ende, durch welches die Charge in den Ofen geschoben und aus diesem entnommen wird. Am anderen Rohrende befindet sich ein Gaseinlass, durch den je nach der gewünschten Gasatmosphäre Stickstoff bzw. Argon oder Sauerstoff und/oder Wasserdampf eingeleitet wird. Bei Bedarf wird zwischen den Gaseinlass und die etwa in der Mitte des Rohrs in einem Boot senkrecht zur Rohrachse und parallel zueinander stehenden Siliciumplättchen eine Schikane gestellt, um eine homogene Verteilung des einströmenden Gases zu gewährleisten. Um Wasserdampf in das Reaktionsrohr zu bringen, wird ausserhalb des Reaktionsrohrs Wasser verdampft, welches dann unter seinem eigenen Druck entweder unvermischt oder in Form eines Sauerstoff/Wasserdampf-Gemisches in den Reaktionsofen strömt. Beim Eintreiben kann dieselbe Bootkonstruktion wie beim Belegen verwendet werden. Die Siliciumplättchen werden dem erfindungsgemässen Verfahren ausgesetzt, um entweder einen dotierten Bereich zu erzeugen, welcher eine ganze Oberfläche des Siliciumplättchens umfasst, oder um, was bei einem fabrikmässigen Einsatz der Normalfall sein dürfte, nur ausgewählte Oberflächenbereiche des Siliciumplättchens zu dotieren. Im letzteren Fall wird das Siliciumplättchen in bekannter Weise mit einer Diffusionsmaske bedeckt, welche bevorzugt aus Siliciumdioxid besteht und an den Stellen, an denen Bor in das Silicium hineindiffundiert werden soll, bis zum Silicium hindurchgehende Fenster aufweist.

Bevor die Plättchen dem ersten Wärmeprozess unterworfen werden können, muss das Reaktionsrohr, sofern seit dem Prozessieren der vorangegangenen Charge schon einige Zeit verstrichen ist oder das Reaktionsrohr gerade frisch gereinigt worden ist, einer Vorbehandlung unterworfen werden. Dazu wird das Reaktionsrohr unter Einhaltung des gewünschten Temperaturprofils auf die Belegungstemperatur erhitzt, und dann lässt man – ohne dass sich dabei Siliciumplättchen im Rohr befinden – ein Gasgemisch durch das Reaktionsrohr strömen, welches dieselbe Zusammensetzung hat, wie wenn man gemäss dem erfindungsgemässen Verfahren Bor auf den Siliciumplättchen niederschlagen will. Diese Vordotierung bewirkt eine Bildung von Borglas auf den Wänden des Reaktionsrohrs, auf der Schikane und auf der Mischkammer. Wird diese Vordotierung bis zur Gleichgewichtseinstellung vorgenommen, so wird erreicht, dass beim Prozessieren einer Charge von Siliciumplättchen kein Bor durch Abscheidung auf den genannten Quarzteilen dem Prozess verlorengeht. Die notwendige Dauer der Dotierung wird ermittelt, indem Plättchen aus Silicium dem Prozess unter denselben Bedingungen wie Produktplättchen unterworfen werden und dann festgestellt wird, ob auf den Testplättchen die spezifizierten Oberflächenwiderstands- und Eindringtiefenwerte oder Dotierungsprofile gemessen werden, ist das nicht der Fall, so wird die Vordotierung fortgesetzt. Es sei bereits an dieser Stelle erwähnt, dass grundsätzlich das Reaktionsrohr, auch wenn gerade keine Chargen prozessiert wurden oder nicht vordotiert wird, auf der Belegungstemperatur gehalten wird und mit Sauerstoff gespült wird. Nachdem eine grössere Anzahl von Chargen (Grössenordnung 10) prozessiert worden sind, wird man feststellen, dass trotz Einhaltung der spezifizierten Prozessbedingungen die Widerstandswerte ansteigen oder abfallen. Ist dieser An- oder Abstieg so stark, dass die erhaltenen Werte ausserhalb des spezifizierten Bereichs liegen, so müssen das Reaktionsrohr und die übrigen Quarzgeräte, welche beim ersten Wärmeprozess zugegen sind, vom Borglas befreit und gereinigt werden.

Die Siliciumplättchen, welche dem ersten Wärmeprozess unterworfen werden sollen, werden bevorzugt auf den mittleren Plätzen des Bootes angeordnet, so dass an beiden Enden noch mehrere vollständig oxidierte Siliciumplättchen Platz finden. Ausserdem werden mit den Produktplättchen noch zwei oder drei Testplättchen prozessiert. Das Boot wird dann in die Reaktionszone geschoben, welche sich entweder bereits auf der Belegungstemperatur oder auf einer 70 bis 100 °C niedrigeren Temperatur befindet. Im letzteren Fall wird das Rohr innerhalb von ungefähr 20 Minuten auf die Belegungstemperatur aufgeheizt. Zunächst sind die Siliciumplättchen einem Gasstrom ausgesetzt, welcher nur aus Argon oder aus Argon mit einem geringen Sauerstoffzusatz besteht. Argon wird gegenüber Stickstoff bevorzugt, weil das letztere mit Silicium geringe Mengen Siliciumnitrid bilden kann. Bevor die Siliciumplättchen einer Bor bzw., wenn zunächst nur mit Argon gespült wurde, einer Bor und Sauerstoff enthaltenden Gasatmosphäre ausgesetzt werden, müssen die Siliciumplättchen auf die festgelegte Belegungstemperatur mit einer Genauigkeit von $\pm 1\,°C$ aufgeheizt sein. Damit sich ein Borglas auf den Siliciumplättchen abscheiden kann, muss das Reaktionsgas Bor und Sauerstoff enthalten. Wie schon gesagt, wird zu diesem Zweck Argon, welches $BBr_3$ enthält, über das Zuleitungsrohr 5 in das im Zuleitungsrohr 4 strömende, als Trägergas dienende Argon geleitet. Das Zuleitungsrohr 4 endet in der Mischkammer, und dort endet auch das Zuleitungsrohr 6, durch welches Sauerstoff eingeleitet wird. Für die Homogenität und die Reproduzierbarkeit der Diffusion ist es wichtig, dass Sauerstoff und $BBr_3$ bei der Belegungstemperatur miteinander reagieren, weshalb die Mischkammer 9 so im Reaktionsrohr positioniert ist, dass sie sich noch praktisch im flachen Teil des Temperaturprofils befindet. In der Mischkammer wird das Gasgemisch kräftig durchgewirbelt und verlässt sie durch die Lochplatte 10. Durch ein Zusammenwirken verschiedener Faktoren, zu denen die Ausbildung der Lochplatte 10, die Ausbildung der Schikane 11, die geometrische Anordnung sowohl der Lochplatte 10 als auch der Schikane 11 zur Reaktionszone, die Gasableitung durch das Ableitungsrohr 8 und nicht zuletzt die Einleitung eines zusätzlichen Argonstroms durch das Einleitungsrohr 7 gehören, wird erreicht, dass alle Siliciumplättchen der Charge über ihre ganze Oberfläche und untereinander exakt derselben Gasatmosphäre ausgesetzt sind. Diese Homogenität der Gasatmosphäre ist wichtig, um homogene und reproduzierbare Diffusionsergebnisse zu erhalten. Dafür ist aber auch entscheidend, wie das $O_2 : BBr_3$-Verhältnis und die $BBr_3$-Menge, welche pro Minute durch das Reaktionsrohr strömt, festgelegt werden. Die $SiB_6$-Phase bildet sich auch noch bei einem $O_2 : BBr_3$-Molverhältnis, welches höher als etwa 65 liegt. Es ist jedoch vorteilhaft, dieses $O_2 : BBr_3$-Verhältnis nicht zu überschreiten. Ein relativ niedriger Sauerstoffgehalt verbessert die Homogenität und Reproduzierbarkeit der Diffusionsergebnisse und – wie weiter unten im einzelnen ausgeführt werden wird – kann es für die Qualität von hochdotierten Borbereichen entscheidend sein, dass bei ihrer Herstellung die Einwirkung von Sauerstoff möglichst gering gehalten wird. Wichtig für die Homogenität und Reproduzierbarkeit der Ergebnisse ist auch, dass wenn das Reaktionsrohr einen Innendurchmesser von etwa 8 cm hat und der Gesamtgasstrom im Bereich zwischen etwa 2 und etwa 5 Liter/Minute liegt, die BBr$_3$-Menge/Minute im Bereich zwischen etwa 15 und 30 Milligramm liegt. Die festgelegte Belegungszeit, welche exakt eingehalten werden muss, richtet sich nach dem angestrebten Oberflächenwiderstand, der Belegungstemperatur und danach, ob beim zweiten Wärmeprozess in einer oxidierenden oder inerten Gasatmosphäre gearbeitet wird. Nach der Belegung werden die Siliciumplättchen, bevor sie aus dem Ofen entnommen werden, entweder noch eine genau festgelegte Zeit lang auf der Belegungstemperatur gehalten, oder sie werden zunächst noch für eine genau festgelegte Zeit auf der Belegungstemperatur gehalten und dann innerhalb von ungefähr 20 Minuten um 70 bis 100 °C abgekühlt, indem der Ofen entsprechend abgekühlt wird. Die festgelegten Zeiten sind auch von den angestrebten Diffusionsprofilen abhängig.

Nach dem Abkühlen der Plättchen auf Raumtemperatur wird das Borglas abgelöst. Die Ätzbarkeit des Borglases hängt ab von dem O$_2$:BBr$_3$-Verhältnis, welches bei seiner Herstellung angewandt worden ist. Borgläser, welche in Gegenwart von relativ viel Sauerstoff hergestellt worden sind, sind leicht in verdünnter Flusssäure löslich. Die verdünnte Flusssäure löst aber auch SiO$_2$, deshalb ist das Ätzen des Borglases mit verdünnter Flusssäure in all den Fällen ungünstig, in denen sich auf den Siliciumplättchen SiO$_2$-Schichten, welche für Maskierungs- und/oder Passivierungszwecke benötigt werden, befinden, weil diese dann in unkontrollierter Weise angegriffen werden können. Das gemäss den erfindungsgemässen Verfahren hergestellte Borglas lässt sich mit verdünnter Flusssäure nicht vollständig entfernen. Für seine vollständige und zuverlässige Entfernung wurde ein Ätzzyklus entwickelt, bei dem die Siliciumplättchen zunächst zehn Sekunden lang in verdünnter Flusssäure ein Teil Flusssäure, zehn Teile Wasser) getaucht werden, anschliessend zehn Minuten lang in auf 95 °C erhitzter konzentrierter Salpetersäure behandelt werden, und schliesslich noch einmal 30 Sekunden lang in verdünnte Flusssäure (1 : 10) getaucht werden. Unter den gewählten Bedingungen wird vorhandenes SiO$_2$ bei dem Ablöseverfahren nicht in wesentlichem Umfang abgelöst. Das erfindungsgemässe Ablöseverfahren hat den weiteren Vorteil, dass die SiB$_6$-Phase und Silicium dabei praktisch nicht angegriffen wird.

Nach dem Ablösen des Borglases werden die Siliciumplättchen dem zweiten Wärmeprozess unterworfen. Dabei ist es nur wichtig, dass die Siliciumplättchen exakt eine festgelegte Zeit lang einer inerten oder oxidierenden Atmosphäre ausgesetzt werden, und dabei eine festgelegte Temperatur genau eingehalten wird. Diese Bedingungen sind mit den heutigen Erfahrungen und verfügbaren Vorrichtungen leicht einzuhalten.

Je nachdem, ob nieder- oder hochdotierte Bereiche erzeugt werden sollen, ist es günstig, spezielle Ausführungsformen des erfindungsgemässen Verfahrens anzuwenden, welche sich in einigen wesentlichen Punkten unterscheiden.

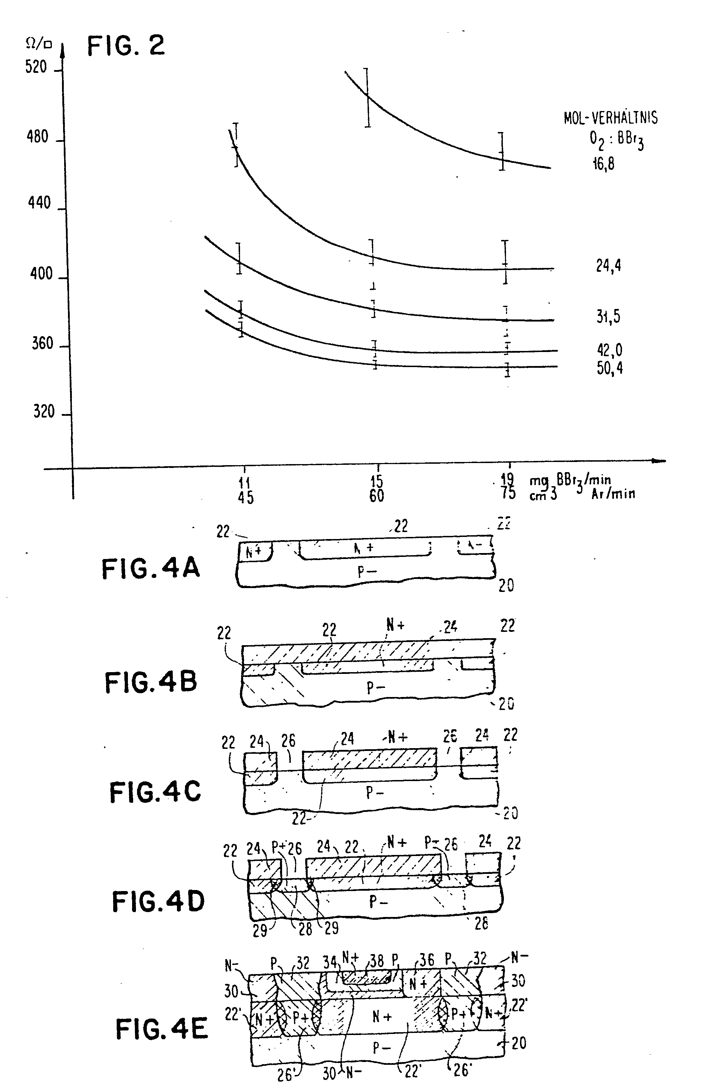

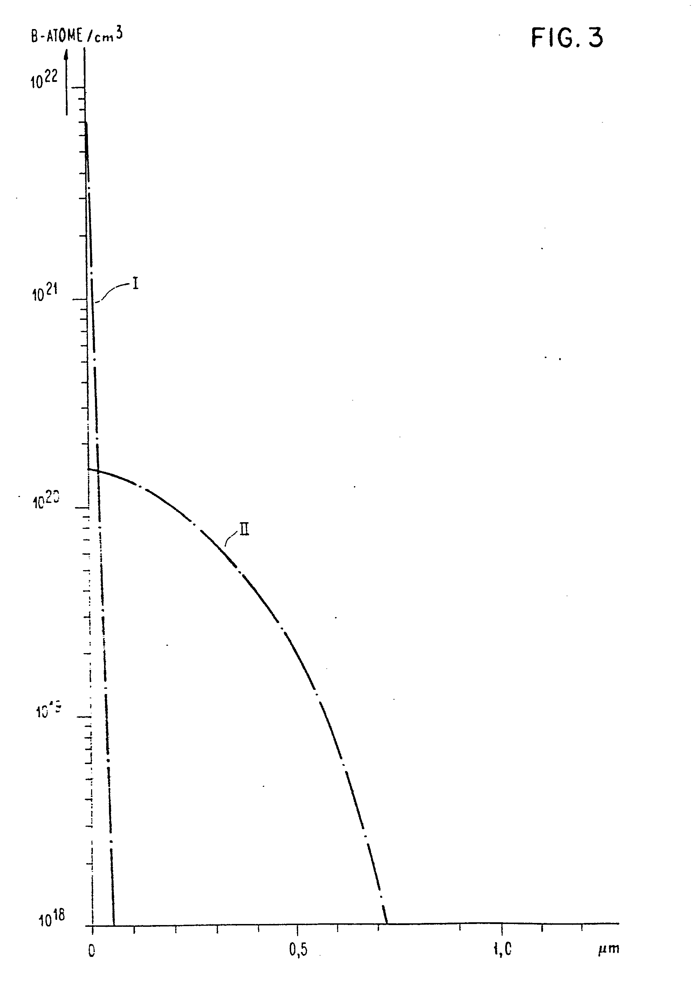

Bei der Erzeugung von niederdotierten Bereichen, d.h. solchen, welche bei einer Eindringtiefe ($x_j$) (Tiefe des P/N-Übergangs) im Bereich zwischen etwa 0,5 und etwa 1 µm einen Oberflächenwiderstand im Bereich zwischen etwa 300 und etwa 600 Ω/□ aufweisen, war es bisher besonders schwierig, homogene Ergebnisse über die Siliciumplättchen und über die Charge mit einer guten Reproduzierbarkeit zu erzielen. Die kleinsten Toleranzen der Oberflächenwiderstandswerte, welche der Anwendung der Verfahren gemäss dem Stand der Technik eingehalten werden konnten, lagen bei Werten $> \pm 13$ Prozent. Es wurde festgestellt, dass bei der Anwendung des erfindungsgemässen Verfahrens zur Herstellung von niederdotierten Bereichen wesentlich engere Toleranzen eingehalten werden können. Es hat sich überraschenderweise herausgestellt, dass dabei bei der Belegung die Einhaltung bestimmter O$_2$:BBr$_3$-Verhältnisse und die Anwendung von BBr$_3$-Mengen/Minute, welche in einem festgelegten Mengenbereich liegen, entscheidend sind. Diese Erkenntnis lässt sich anhand der Fig. 2 veranschaulichen. Die Fig. 2 zeigt ein Diagramm, in welchem Oberflächenwiderstandswerte, welche in Bor-dotierten Bereichen gemessen wurden, nachdem sie allen Hochtemperaturprozessen, welchen Siliciumplättchen bei der Herstellung bipolarer Transistoren ab der Basisdiffusion unterworfen werden, ausgesetzt worden waren, gegen BBr$_3$-Mengen/Minute für verschiedene O$_2$:BBr$_3$-Molverhältnisse aufgetragen sind. Die übrigen Prozessparameter waren dieselben wie in den Beispielen 1 bis 4 (siehe Tabelle I). Man kann der Fig. 2 entnehmen, dass wenn man ausgehend von kleinen BBr$_3$-Mengen und von relativ kleinen O$_2$:BBr$_3$-Molverhältnissen zu grösseren BBr$_3$-Mengen bzw. zu grösseren O$_2$:BBr$_3$-Molverhältnissen übergeht, die Oberflächenwiderstandswerte zunehmend unempfindlicher gegenüber Änderungen dieser beiden Parameter werden. Es ist einleuchtend, dass man unter Ausnutzung dieser beiden Tendenzen die Homogenität und die Reproduzierbarkeit der erzielbaren Ergebnisse beachtlich steigern kann. Da weiter festgestellt wurde, dass wenn man das O$_2$:BBr$_3$-Molverhältnis über den Wert von etwa 65 hinaus steigert, die Einheitlichkeit des Borglases abnimmt und die Streuung der Oberflächenwiderstandswerte zunimmt, ergibt sich, dass die günstigsten O$_2$:BBr$_3$-Molverhältnisse zwischen etwa 20 und etwa 65 liegen. Wird bei einem O$_2$:BBr$_3$-Verhältnis in diesem Bereich bei einer Temperatur im Bereich zwischen 850 und 950 °C und bei einer Belegungszeit in der Grössenordnung von 20 Minuten gearbeitet, so ist es vorteilhaft, zur Erreichung von Oberflächenwiderstandswerten im Bereich zwischen etwa 300 und etwa 600 Ω/□ eine

BBr$_3$-Menge pro Minute im Bereich zwischen etwa 15 und etwa 30 Milligramm einzustellen. Während des ersten Wärmeprozesses strömen an den Siliciumplättchen, welche einen Durchmesser von ungefähr 57 mm haben und in einem Reaktionsrohr mit einem Innendurchmesser von ungefähr 8 cm stehen, ein Argonstrom im Bereich zwischen etwa 3 und etwa 4 Liter/Minute und ein Sauerstoffstrom im Bereich zwischen etwa 0,05 und etwa 0,15 Liter/Minute vorbei. Ausserdem strömt noch ein Argonstrom von ungefähr 0,5 Liter/Minute, welcher eine stabilisierende Funktion hat, von der Reaktionsrohröffnung her dem Ar/O$_2$-Gemisch entgegen. Während der Belegungsphase wird dem Ar/O$_2$-Gemisch mit BBr$_3$ beladenes Argon zugemischt. Beim Eintreiben des Bors in das Silicium hinein wird bei der Erzeugung niedrig mit Bor dotierter Gebiete in einer oxidierenden Atmosphäre gearbeitet, wobei eine für Maskierungs- und Passivierungszwecke verwendbare SiO$_2$-Schicht aufwächst, und ausserdem ein wesentlicher Teil des im Silicium befindlichen Bors im Oxid gelöst wird, wodurch sich der Oberflächenwiderstand stark erhöht. Es wird zunächst mit reinem Sauerstoff, anschliessend zur Beschleunigung des Oxidationsvorganges eine längere Zeit mit Wasserdampf und schliesslich noch einmal mit reinem Sauerstoff oxidiert.

Bei der Herstellung von hoch Bor-dotierten Bereichen unter Anwendung des erfindungsgemässen Verfahrens wird die Einwirkung des Sauerstoffs nicht nur aus Gründen der angestrebten Homogenität und Reproduzierbarkeit der Ergebnisse, sondern auch deshalb eingeschränkt, damit in den Fällen, in welchen die hoch Bor-dotierten Bereiche mit hoch Arsen-dotierten Bereichen überlappen oder in solchen erzeugt werden, sich keine Kristallversetzungen bilden. Deshalb wird bei der Herstellung hochdotierter Bereiche Sauerstoff, welcher mit BBr$_3$ zu Boroxid reagiert, nur während des Abscheidens von Boroxid auf dem Siliciumplättchen dem Gasgemisch zugemischt. Während des Aufheizens, des Nachbehandelns und des Abkühlens der Plättchen fliesst durch das Reaktionsrohr und über die Plättchen nur ein Argon enthaltender Gasstrom (Ar$_H$), dem von der Reaktionsrohröffnung her ein Argonstrom (Ar$_S$) entgegenströmt. Während der nur zwischen drei und fünf Minuten dauernden Belegungsphase wird der Argonstrom (Ar$_H$) über die Plättchen verstärkt und ihm ausserdem Bor und Sauerstoff zugemischt. Das O$_2$:BBr$_3$-Molverhältnis ist dabei bevorzugt nicht grösser als 65 und, um nach dem Eintreiben im zweiten Wärmeprozess bei einer Eindringtiefe im Bereich zwischen etwa 0,5 und etwa 1 µm einen Oberflächenwiderstand im Bereich zwischen 30 und 40 Ω/□ zu erhalten, wird, wenn man im ersten Wärmeprozess bei Temperaturen im Bereich zwischen etwa 950 und 1000°C arbeitet – bei einem Rohrinnendurchmesser von etwa 8 cm und einem Gesamtgasstrom im Bereich zwischen etwa 2 und etwa 5 Liter/Minute –, eine BBr$_3$-Menge/Minute im Bereich zwischen etwa 15 und 30 Milligramm/Minute eingestellt. Zur Herstellung hochdotierter Bereiche gemäss dem erfindungsgemässen Verfahren wird beim Eintreiben im zweiten Wärmeprozess in einer inerten Gasatmosphäre bei Temperaturen im Bereich zwischen etwa 950 und 1050°C gearbeitet. Beim Eintreiben in einer inerten Atmosphäre geht zwar einiges Bor durch Ausdiffusion aus dem Silicium verloren, jedoch verarmt das Silicium wesentlich weniger an Bor als beim oxidierenden Eintreiben, bei dem ein wesentlicher Teil des im Silicium befindlichen Bors sich in dem aufwachsenden Siliciumdioxid löst. Deshalb reicht unter den angewandten Bedingungen eine Belegungsphase, welche zwischen drei und fünf Minuten dauert, aus, um die notwendige Menge Boroxid auf dem Silicium niederzuschlagen. Wird weniger als drei Minuten belegt, so wird es schwierig, den Prozess zu steuern. Die Borprofile, welche sich bei Anwendung des erfindungsgemässen Verfahrens unter typischen Bedingungen während des ersten und des zweiten Wärmeprozesses bilden, sind aus der Fig. 3 ersichtlich. Fig. 3 zeigt ein Diagramm, in welchem die Borkonzentrationen über den zugehörigen Abständen von der Oberfläche eines kein Arsen enthaltenden Siliciumbereiches aufgetragen sind. Die Kurve I zeigt dabei das Borprofil nach dem ersten Wärmeprozess und die Kurve II das Borprofil nach dem zweiten Wärmeprozess. Man ersieht aus der Fig., dass nach dem ersten Wärmeprozess die Konzentration des Bors an der Oberfläche (C$_{oB}$) grössenordnungsmässig $10^{22}$ Boratome/cm$^3$ beträgt und die Eindringtiefe unter 0,1 µm liegt. Nach dem Eintreiben liegt die Oberflächenkonzentration des Bors (C$_{oB}$) immer noch oberhalb $10^{20}$ Boratomen/cm$^3$, und die Eindringtiefe liegt bei ungefähr 0,7 µm. Die nach dem Eintreiben mittels einer photometrischen Analysenmethode gemessene Bordosis liegt bei $4,5\cdot10^{15}$ Boratomen/cm$^3$. Entsprechende Werte, welche bei der Herstellung von hochdotierten Borbereichen mittels eines üblichen Verfahrens gemäss dem Stand der Technik erhalten worden sind, sind nach dem ersten Wärmeprozess ein C$_{oB}$ von $5,5\cdot10^{20}$ Boratomen/cm$^3$ und ein x$_j$ von 0,6 µm und nach dem Eintreiben ein C$_{oB}$ von $3\cdot10^{19}$ Boratomen/cm$^3$ und ein x$_j$ von 1,4 µm. Man sieht also, dass die Konzentrationswerte bei der Herstellung von hochdotierten Bereichen gemäss dem erfindungsgemässen Verfahren höher sind als bei der Herstellung solcher Bereiche mittels üblicher Verfahren gemäss dem Stand der Technik. Wie schon oben darauf hingewiesen wurde, ist es überraschend, dass in den Überlappungsbereichen zwischen einem hoch mit Arsen dotiertem Gebiet (typische Oberflächenkonzentration C$_{oAs}$ ungefähr $10^{21}$ Arsenatome/cm$^3$) mit einem gemäss dem erfindungsgemässen Verfahren hergestellten, hoch mit Bor dotiertem Gebiet nicht die aus dem Stand der Technik bekannten Kristallversetzungen auftreten.

Anhand der Fig. 4A bis 4E soll nun zur weiteren Erläuterung des erfindungsgemässen Verfahrens die Erzeugung einer Halbleiterstruktur beschrieben werden, wobei bei dieser Erzeugung das erfindungsgemässe Verfahren in vorteilhafter Weise angewandt werden kann. Fig. 4A zeigt ein schwach P-dotiertes Substrat, in welchem stark N-dotierte Bereiche 22 ausgebildet sind. Auf dieser Struktur wird durch thermische Oxidation ganzflächig eine Siliciumdioxidschicht 24 aufgebracht. Das Ergebnis dieser Operation zeigt die Fig. 4B. In der Schicht 24 wird nun die Diffusionsmaske für die Subisolationsdiffusion erzeugt, indem entsprechend den gewünschten Abmessungen und der gewünschten geometrischen Anordnung der Diffusionsgebiete Stellen bis zum Substrat 20 durchgehende Öffnungen 26 in der Siliciumdioxidschicht 24 erzeugt werden. Das Ergebnis zeigt die Fig. 4C. Anschliessend wird die Struktur dem erfindungsgemässen Verfahren zur Erzeugung stark P-dotierter Bereiche 28 unterworfen. Das Ergebnis zeigt die Fig. 4D, in der auch die Überlappungsgebiete 29 zwischen den mit Arsen hoch N-dotierten Bereichen 22 und den mit Bor hoch P-dotierten Bereichen 28 zu sehen sind. Anschliessend wird die Siliciumdioxidschicht 24 abgelöst und stattdessen ganzflächig die Epitaxieschicht 30 aufgewachsen. Dabei werden im Wege der Ausdiffusion die Arsenatome und die Boratome aus den Bereichen 22 bzw. 28 teilweise in die über diesen Bereichen gelegenen Bereiche der Epitaxieschicht eingebaut. Dabei entstehen die in der Fig. 4E gezeigten, stark N-dotierten Bereiche 22' und die stark P-dotierten Bereiche 26'. Anschliessend wird die Struktur selektiv einer weiteren Bordiffusion unterworfen, wobei in vorteilhafter Weise das erfindungsgemässe Verfahren Anwendung finden kann. Bei dieser Bordiffusion werden schwach P-dotierte Bereiche 32 und 34 erzeugt, wobei die Bereiche 32 zusammen mit den Bereichen 26' Isolationszwecken und die Bereiche 34 als Basiszonen von bipolaren Transistoren dienen. Anschliessend werden noch in bekannter Weise stark N-dotierte Bereiche 36 und 38 erzeugt, wobei die Bereiche 36 zur Erleichterung des Kollektoranschlusses und zur Verbindung zwischen der Siliciumoberfläche und den Subkollektorbereichen 22' und die Bereiche 38 als Emitterbereiche von bipolaren Transistoren dienen. Die fertige Struktur zeigt die Fig. 4E. Die Anwendung des erfindungsgemässen Verfahrens bei den beschriebenen Bordiffusionen bei der Herstellung der in der Fig. 4E gezeigten Struktur hat verschiedene wesentliche Vorteile gegenüber der Anwendung bekannter Verfahren. Wird das erfindungsgemässe Verfahren für die Durchführung der Subisolationsdiffusion verwendet, so werden sich in den Überlappungsgebieten 29 keine Kristallversetzungen bilden, wie es der Fall wäre, wenn die Subisolationsdiffusion gemäss bekannter offener Diffusionsverfahren durchgeführt würde. Die Versetzungen hätten erstens eine unkon-

Tabelle I

| Beispiel | 1 | 2 | 3 | 4 |
|---|---|---|---|---|
| **1. Wärmeprozess** | | | | |
| $T(°C)$ | $875 \pm 1$ | $875 \pm 1$ | $875 \pm 1$ | $875 \pm 1$ |
| $Ar_H$ (l/min)* | 3,2 | 3,2 | 3,2 | 3,2 |
| $O_2$ (l/min)* | 0,08 | 0,06 | 0,08 | 0,08 |
| $Ar_S$ (l/min)* | 0,5 | 0,5 | 0,5 | 0,5 |
| Vorbehandlung A (min)** | 15 | 5 | 15 | 15 |
| Belegen A (min) | 20 | 28 30 | 10 | 8 |
| $Ar_{BBr3}$ (l/min) | 0,08 | 0,06 | 0,08 | 0,08 |
| Nachbehandlung A (min) | 15 | 15 10 | 15 | 15 |
| Borglasdicke (nm) | 80 | 200 | 60 | 40 |
| $R_{s1}$ ($\Omega/\square$) | $111 \pm 2$ | $85 \pm 1$ | $125 \pm 3$ | $140 \pm 4$ |
| $x_{j1}$ ($\mu$m) | $0,15 \pm 0,1$ | 0,15 | 0,15 | 0,15 |
| **2. Wärmeprozess** | | | | |
| $T(°C)$ | $925 \pm 1$ | $925 \pm 1$ | $925 \pm 1$ | $925 \pm 1$ |
| A (min) | 10 | 10 | 10 | 10 |
| $O_2$ (l/min) | 1,5 | 1,5 | 1,5 | 1,5 |
| A (min) | 51 | 51 | 51 | 51 |
| $H_2O_D$ | ja | ja | ja | ja |
| A (min) | 10 | 10 | 10 | 10 |
| $O_2$ (l/min) | 1,5 | 1,5 | 1,5 | 1,5 |
| $R_{s2}$ ($\Omega/\square$) | $450 \pm 30$ | $330 \pm 20$ | $500 \pm 30$ | $700 \pm 30$ |
| $x_{j2}$ ($\mu$m) | $0,45 \pm 0,1$ | 0,45 | 0,45 | 0,45 |
| **3. Wärmeprozess** | | | | |
| A (min) | 180 | 180 | 180 | 180 |
| $T(°C)$ | 1000 | 1000 | 1000 | 1000 |
| $R_{s3}$ ($\Omega/\square$) | $400 \pm 20$ | $300 \pm 20$ | $520 \pm 25$ | $660 \pm 25$ |
| $x_{j3}$ ($\mu$m) | $0,75 \pm 0,1$ | $0,75 \pm 0,1$ | $0,75 \pm 0,1$ | $0,75 \pm 0,1$ |

* während des ganzen 1. Wärmeprozesses
** A (min) bedeutet Zeitdauer in Minuten

trollierte Ausdiffusion der Bereiche 22' und 26' in die Epitaxieschicht 30 hinein zur Folge, und ausserdem würde durch die Ausbreitung der Versetzungen in die den Überlappungsgebieten 29 benachbarten Bereiche der Struktur die Wahrscheinlichkeit der Bildung von Kollektor-Emitter-Kurzschlüssen in den bipolaren Transistoren drastisch erhöht. Als weiterer Vorteil der Anwendung des erfindungsgemässen Verfahrens bei der Subisolationsdiffusion kommt hinzu, dass die Eindringtiefe der Diffusion nach dem zweiten Wärmeprozess geringer ist als bei den Verfahren gemäss dem Stand der Technik, was zur Folge hat, dass die laterale Ausdiffusion des Bors nach Aufwachsen der Epitaxieschicht geringer ist als nach der Anwendung eines bekannten Bordiffusionsverfahrens. Da das erfindungsgemässe Verfahren bei der Herstellung von niederdotierten Gebieten, wie z. B. den Basiszonen, wesentlich homogenere und reproduzierbarere Ergebnisse liefert als die Verfahren gemäss dem Stand der Technik, kann bei Anwendung des erfindungsgemässen Verfahrens wegen der besseren Kontrolle die Basisweite kleiner gemacht werden als bei Anwendung von bekannten Verfahren. Zusammengenommen lässt sich sagen, dass bei Anwendung des erfindungsgemässen Verfahrens wesentlich zuverlässigere und gleichzeitig dichter gepackte und höher integrierte Schaltungen erzeugt werden können.

Zur weiteren Verdeutlichung des erfindungsgemässen Verfahrens werden im folgenden die bei den Wärmeprozessen angewandten Verfahrensparameter und die Ergebnisse von sechs Ausführungsbeispielen angegeben. Bei den in der Tabelle I angegebenen Beispielen 1 bis 4 handelt es sich um Bordiffusionen zur Erzeugung niederdotierter Bereiche und bei den in der Tabelle II aufgeführten Beispielen 6 und 7 um Bordiffusionen zur Erzeugung von hochdotierten Bereichen. Bei den Beispielen wird jeweils nach dem ersten Wärmeprozess das Borglas abgelöst. Bei den Beispielen 1 bis 4 wird noch ein dritter Wärmeprozess durchgeführt, bei dem die Siliciumplättchen denselben Temperaturbedingungen wie bei der Herstellung des Emitters eines bipolaren Transistors unterworfen werden. Auch die Ergebnisse dieses dritten Wärmeprozesses sind in der Tabelle I aufgeführt. Das Reaktionsrohr hatte bei allen Beispielen einen Innendurchmesser von ungefähr 8 cm und die Siliciumplättchen einen Durchmesser von ungefähr 57 mm.

In den Tabellen bedeuten $Ar_H$ den aus Argon bestehenden Hauptstrom, $Ar_s$ den dem Hauptstrom entgegenströmenden Stabilisierungsstrom, Ar ($BBr_3$) einen Argonstrom, welcher dadurch mit $BBr_3$ beladen wurde, dass er durch auf 5 °C erwärmtes $BBr_3$ geleitet wurde, wobei 100 Milliliter Argon 25 Milligramm $BBr_3$ aufnehmen, $Rs_1$, $Rs_2$ und $Rs_3$ bedeuten die Oberflächenwiderstände und $xj_1$, $xj_2$, $xj_3$ die Eindringtiefen nach der ersten, zweiten und dritten Wärmebehandlung, BSG steht für Borglas und $H_2O_D$ für Wasserdampf.

Tabelle II

| Beispiel | | 5 | 6 |
|---|---|---|---|
| **1. Wärmeprozess** | | | |
| schnell Aufheizen | T(°C) | R.T.–900 | R.T.–970 |
| langsames Aufheizen | T(°C) | 900–970 | 970 |
| bzw. Vorbehandlung | A (min)** | 22 | 15 |
| | Ar (l/min) | 1,5 | 1,5 |
| | $Ar_s$ (l/min)* | 0,5 | 0,5 |
| Belegen | T(°C) | 970 ± 1 | 970 ± 1 |
| | A (min) | 4 | 4 |
| | $Ar_H$ (l/min) | 3,6 | 3,6 |
| | $O_2$ (l/min) | 0,1 | 0,1 |
| | $Ar_{BBr_3}$ (l/min) | 0,1 | 0,1 |
| Nachbehandlung | A (min) | 5 | 10 |
| langsames Abkühlen | Ar (l/min) | 1,5 | 1,5 |
| | T(°C) | 970–900 | |
| | A (min) | 20' | entfällt |
| | Ar (l/min) | 1,5 | |
| rasch Abkühlen | T(°C) | 900-R.T. | 970-R.T. |
| | Borglasdicke (nm) | 50–80 | 50–80 |
| | $R_{s1}$ (Ω/□) | 65 ± 5 | 100 ± 5 |
| | $x_{j1}$ (µm) | ≪ 0,1 | ≪ 0,1 |
| **2. Wärmeprozess** | | | |
| | T(°C) | 1000 ± 1 | 1000 ± 1 |
| | A (min) | 80 | 80 |
| | $N_2$ oder Ar (l/min) | 1 | 1 |
| | $R_{s2}$ (Ω/□) | 32 ± 4 | 75 ± 5 |
| | $x_{j2}$ (µm) | 0,8 ± 0,1 | 0,8 ± 0,1 |

* fliesst während des ganzen 1. Wärmeprozesses
** A (min) bedeutet Zeitdauer in Minuten

Der Tabelle I ist im besonderen zu entnehmen: die geringe Streuung der Rs-Werte auch nach der letzten Wärmebehandlung und dass diese geringe Streuung auch in einem grossen Widerstandsbereich erhalten wird. Aus dem Beispiel 2 geht zusätzlich hervor, dass günstige Ergebnisse auch erhalten werden, wenn, sofern dies erwünscht ist, die Belegung in zwei durch eine oxidierende Wärmebehandlung unterbrochene Schritte durchgeführt wird. Aus der Tabelle II ergibt sich insbesondere, dass es bei dem ersten Wärmeprozess offenbar sehr genau auf eine genaue Einhaltung der Belegungszeit ankommt.

**Patentansprüche**

1. Verfahren zum Dotieren von Siliciumkörpern durch Eindiffundieren von Bor, bei dem in einem ersten Wärmeprozess eine die höchstens teilweise maskierte Oberfläche der Siliciumkörper bedeckende Borglasschicht und unter dieser in den nicht maskierten Bereichen eine $SiB_6$-Schicht erzeugt werden, indem die Siliciumkörper einem eine festgelegte Bormenge und Bor und Sauerstoff in einem festgelegten Mengenverhältnis enthaltenden Gasgemisch ausgesetzt werden, bei dem vor einem zweiten Wärmeprozess das Borglas vollständig abgelöst wird, ohne dass dabei die $SiB_6$-Schicht wesentlich angegriffen wird, und bei dem im zweiten Wärmeprozess Bor in das Silicium hineingetrieben wird, gekennzeichnet durch seine Verwendung zur Erzeugung von in sich und untereinander homogen dotierten Bereichen.

2. Verfahren nach Anspruch 1, dadurch gekennzeichnet, dass das $O_2$:B-Verhältnis und die pro Zeiteinheit dem Gasgemisch zugefügte Bormenge so festgelegt wird, dass ein Borglas entsteht, welches in gepufferter Flusssäure nur unvollständig, jedoch durch eine Behandlung in Flusssäure, dann in heisser Salpetersäure und schliesslich noch einmal in Flussäure ohne Rückstand entfernt wird.

3. Verfahren nach Anspruch 2, dadurch gekennzeichnet, dass die Siliciumkörper 10 Sekunden lang in im Verhältnis 1:10 mit Wasser verdünnte Flusssäure, dann 10 Minuten lang in auf 95 °C erhitzte konzentrierte Salpetersäure und schliesslich 30 Sekunden lang in Flusssäure (1:10) getaucht werden.

4. Verfahren nach einem oder mehreren der Ansprüche 1 bis 3, dadurch gekennzeichnet, dass als Borquelle Borbromid ($BBr_3$) verwendet wird und die Siliciumkörper einem bei der Diffusionstemperatur aus $BBr_3$ und $O_2$ entstandenen und in einem strömenden Trägergas enthaltenen Gemisch ausgesetzt werden.

5. Verfahren nach einem oder mehreren der Ansprüche 1 bis 4, dadurch gekennzeichnet, dass beim ersten Wärmeprozess unter Zugrundelegung eines inneren Durchmessers des Reaktionsrohrs von ungefähr 8 cm mit einem Trägergasfluss im Bereich zwischen 2 und 5 Liter/Minute und einem Stabilisierungsgasfluss im Bereich zwischen 0,5 und 1 Liter/Minute gearbeitet wird und dass dem Trägergas während des Belegens $BBr_3$-Mengen im Bereich zwischen etwa 15 und etwa 30 Milligramm/Minute und mindestens während des Belegens eine derart auf die $BBr_3$-Menge abgestimmte Sauerstoffmenge zugefügt werden, dass das $O_2$:$BBr_3$-Molverhältnis im Bereich zwischen etwa 20 und etwa 65 liegt.

6. Verfahren nach einem oder mehreren der Ansprüche 1 bis 5, dadurch gekennzeichnet, dass während des ersten Wärmeprozesses die in einem Boot (12) angeordneten, in der Form von Siliciumplättchen (13) vorliegenden Siliciumkörper senkrecht zum Gasstrom in eine ein flaches Temperaturprofil aufweisende Reaktionszone gestellt werden, in welche das aus einer Mischkammer (9) kommende Gasgemisch durch eine etwa den Rohrquerschnitt ausfüllende Lochplatte (10) geleitet wird, und welche durch die Lochplatte (10) und durch eine aus zwei miteinander verbundenen, etwa den Rohrquerschnitt ausfüllenden und zur Rohrachse senkrecht stehenden Quarzscheiben bestehende Schikane (11) begrenzt wird, wobei das Gasgemisch zwischen den Quarzscheiben der Schikane (11) durch ein Ableitungsrohr (8) abgeleitet und zwischen der Schikane (11) und dem mit einer Schliffkappe (3) verschlossenen Rohrende (2) des Stabilisierungsgases durch ein Zuleitungsrohr (7) eingeleitet wird.

7. Verfahren nach einem oder mehreren der Ansprüche 1 bis 6, dadurch gekennzeichnet, dass die Reaktionszone im Ofen für den ersten Wärmeprozess, wenn keine Charge sich im Reaktionsrohr befindet bzw. nicht vordotiert wird, ständig auf der Belegungstemperatur gehalten und das Rohr mit Sauerstoff gespült wird und dass, wenn während einer festgelegten Zeit keine Charge im Reaktionsrohr prozessiert worden ist bzw., wenn das Reaktionsrohr frisch gereinigt worden ist, das Reaktionsrohr vor der erneuten Benutzung eine festgelegte Zeit lang durch Einleiten des während der Belegung fliessenden Gasgemisches bei der Belegungstemperatur vordotiert wird.

8. Verfahren nach einem oder mehreren der Ansprüche 1 bis 7, dadurch gekennzeichnet, dass wenn die unter den gleichen Bedingungen erhaltenen und aufgetragenen Oberflächenwiderstandswerte aufeinanderfolgender Chargen anzusteigen oder abzufallen beginnen, das Reaktionsrohr für den ersten Wärmeprozess vom Borglas befreit und gereinigt wird.

9. Verfahren nach einem oder mehreren der Ansprüche 1 bis 8, dadurch gekennzeichnet, dass beim ersten Wärmeprozess bei einer Temperatur im Bereich zwischen etwa 850 und etwa 950 °C gearbeitet und der zweite Wärmeprozess in einer oxidierenden Atmosphäre durchgeführt wird.

10. Verfahren nach Anspruch 9, dadurch gekennzeichnet, dass über die in einem Reaktionsrohr mit einem Innendurchmesser von ungefähr 8 cm stehenden Siliciumplättchen bei einer Temperatur von 875 ± 1 °C zunächst 15 Minuten lang ein aus 3,2 Liter Argon pro Minute und 0,08 Liter Sauerstoff pro Minute bestehendes Gasgemisch, dann 20 Minuten lang dieses Gasgemisch, dem zusätzlich 0,08 Liter Argon pro Minute, welches zuvor bei einer Temperatur von 5°C mit BBr₃ gesättigt worden war, und schliesslich noch einmal 15 Minuten lang das zuerst verwendete Gasgemisch geleitet wird, dass nach dem Abkühlen die Borglasschicht abgelöst wird und anschliessend bei 925 ± 1 °C über die Siliciumplättchen zunächst 10 Minuten lang 1,5 Liter Sauerstoff pro Minute, dann 51 Minuten lang Wasserdampf und schliesslich 10 Minuten lang noch einmal 1,5 Liter Sauerstoff pro Minute geleitet werden.

11. Verfahren nach einem oder mehreren der Ansprüche 1 bis 8, dadurch gekennzeichnet, dass beim ersten Wärmeprozess die beim Eintreiben benötigte Bormenge bei Temperaturen im Bereich zwischen etwa 950 und etwa 1000 °C unter Einwirkung von möglichst wenig Sauerstoff im wesentlichen in die $SiB_6$-Schicht eingebaut wird und dass beim zweiten Wärmeprozess in einer inerten Gasatmosphäre gearbeitet wird.

12. Verfahren nach Anspruch 1, dadurch gekennzeichnet, dass die Siliciumkörper in einer Argonatmosphäre innerhalb von etwa 22 Minuten von etwa 900 auf 970 °C erhitzt, anschliessend bei 970 °C 4 Minuten lang einem fliessenden Gasgemisch von 3,6 Liter Argon pro Minute, 0,1 Liter Sauerstoff pro Minute und 0,1 Liter Argon pro Minute, welches zuvor bei einer Temperatur von + 5 °C mit BBr₃ gesättigt worden war, und daraufhin 5 Minuten lang einem Argonstrom von 1,5 Liter pro Minute ausgesetzt und dann innerhalb von 20 Minuten in einer Argonatmosphäre von 970 auf etwa 900 °C abgekühlt werden, dass nach dem Entnehmen aus dem Ofen das Borglas vollständig abgelöst und schliesslich die Siliciumplättchen 80 Minuten lang bei 1000 °C in einer Stickstoff- oder Argonatmosphäre behandelt werden.

### Claims

1. Method of doping silicon bodies through the diffusion of boron into these bodies, where in a first heating process a boron glass layer covering the at most partially masked surface of the silicon bodies, and beneath said layer an $SiB_6$ layer in the unmasked areas are generated in that the silicon bodies are exposed to a gas mixture containing a predetermined boron quantity and boron and oxygen in a predetermined quantitative ratio, where prior to a second heating process the boron glass is completely removed without the $SiB_6$ layer being substantially affected, and where in the second heating process boron is driven into the silicon, characterized by its use for the generation of regions which are each one and among each other homogeneously doped.

2. Method as claimed in claim 1, characterized in that the $O_2$:B ratio and the boron quantity added per time unit to the gas mixture are determined in such a manner that a boron glass is obtained which is incompletely removed in buffered hydrofluoric acid but which through processing in hydrofluoric acid, then in hot nitric acid, and finally once more in hydrofluoric acid is removed without any residue.

3. Method as claimed in claim 2, characterized in that the silicon bodies are immersed for 10 seconds in hydrofluoric acid diluted with water in a ratio of 1:10, subsequently for 10 minutes in a concentrated nitric acid heated to 95°C, and finally for 30 seconds in hydrofluoric acid (1:10).

4. Method as claimed in one or several of claims 1 to 3, characterized in that boronbromide (BBr₃) is used as boron source, and that the silicon bodies are exposed to a mixture generated in the diffusion temperature of BBr₃ and $O_2$, and contained in a flowing carrier gas.

5. Method as claimed in one or several of claims 1 to 4, characterized in that the first heating process is effected with an inner diameter of the reaction tube of approximately 8 cm being assumed with a carrier gas flow between 2 and 5 liter/minute and a stabilizing gas flow between 0.5 and 1 liter/minute, and that during coating BBr₃ quantities are added to the carrier gas in an amount between approximately 15 and approximately 30 milligram/minute, and at least during coating an oxygen quantity adapted to the BBr₃ quantity in such a manner that the $O_2$:BBr₃ molar ratio lies between approximately 20 and approximately 65.

6. Method as claimed in one or several of claims 1 to 5, characterized in that during the first heating process the silicon bodies arranged in a boat (12), and existing in the form of silicon wafers (13) are placed perpendicularly to the gas flow in a reaction zone showing a flat temperature profile, into which zone the gas mixture from a mixing chamber (9) is directed through a perforated plate (10) approximately filling the tube cross-section, and which is limited by the perforated plate (10) and by a baffle (11) consisting of two interconnected quartz disks which approximately fill the tube cross-section and perpendicular to the tube axis, the gas mixture passing between the quartz disks of the baffle (10) through a drain tube (8) and the stabilizing gas being supplied through a supply tube (7) between the baffle (11) and the tube end (2) closed with a ground cap (3).

7. Method as claimed in one or several of claims 1 to 6, characterized in that when there is no batch in the reaction tube, or if no pre-dopings take place, the reaction zone in the furnace for the first heating process is continously kept at the coating temperature and that the tube is flushed with oxygen, and that when during a predetermined time no batch has been processed in the reaction tube, or if the reaction tube has just been cleaned, the reaction tube prior to be used again is pre-doped at coating temperature for a predetermined period by means of introducing the gas mixture which flows during coating.

8. Method as claimed in one or several of claims 1 to 7, characterized in that when the surface resistance rates of successive batches obtained and plotted for the same conditions begin to increase or decrease, the reaction tube is cleaned of the boron glass for the first heating process.

9. Method as claimed in one or several of claims 1 to 8, characterized in that the first heating process operation takes place at a temperature between approximately 850 and approximately 950°C, and that the second heating process is executed in an oxidizing atmosphere.

10. Method as claimed in claim 9, characterized in that over the silicon wafers provided in a reaction tube with an inner diameter of approximately 8 cm, at a temperature of 875 ± 1°C, first for 15 minutes a gas mixture consisting of 3.2 liters argon/minute and 0.08 liters oxygen/minute is directed, subsequently for 20 minutes this gas mixture with additional 0.08 liters argon/minute which previously had been saturated at a temperature of 5°C with BBr₃, and finally for another 15 minutes the first-used gas mixture, that after cooling the boron glass layer is removed, and that subsequently at 925 ± 1°C for 10 minutes 1.5 liters oxygen per minute, then for 51 minutes steam, and finally for 10 minutes again 1.5 liters oxygen per minute are directed over the silicon wafers.

11. Method as claimed in one or several of claims 1 to 8, characterized in that the first heating process the boron quantity required for drive-in is substantially inserted into the SiB₆ layer at temperatures between approximately 950 and approximately 1000°C, under the influence of a minimum of oxygen, and that in the second heating process operation takes place in an inert gas atmosphere.

12. Method as claimed in claim 1, characterized in that the silicon bodies are heated in an argon atmosphere for approximately 22 minutes to approximately 900 to 970°C, that subsequently they are exposed at 970°C for 4 minutes to a flowing gas mixture of 3.6 liters argon per minute, 0.1 liter oxygen per minute, and 0.1 liter argon per minute which previously had been saturated at a temperature of +5°C with BBr₃, and that subsequently it is exposed for 5 minutes to an argon stream of 1.5 liters per minute, and then for 20 minutes cools in an argon atmosphere from 970 to approximately 900°C, that after having been taken out of the furnace the boron glass is completely removed, and that finally the silicon wafers are processed for 80 minutes at 1000°C in a nitrogen or argon atmosphere.

**Revendications**

1. Procédé pour doper des corps de silicium par diffusion de bore, dans lequel on produit dans un premier procédé thermique une couche de verre de bore couvrant la surface masquée du corps de silicium tout au plus partiellement et sous cette couche, une couche de SiB₆ dans les régions non masquées, en exposant les corps de silicium à un mélange de gaz comportant une quantité de bore donnée et, du bore et de l'oxygène dans une proportion donnée; dans lequel on enlève le verre de bore complètement avant un second procédé thermique sans attaquer la couche de SiB₆ essentiellement, et dans lequel on étale le bore dans le silicium dans un second procédé thermique; ledit procédé étant caractérisé par son application pour produire des régions qui sont dopées de façon homogène prises individuellement ou les unes par rapport aux autres.

2. Procédé selon la revendication 1, caractérisé en ce que la proportion O₂:B et la quantité de bore ajoutée au mélange de gaz par unité de temps sont déterminées de telle sorte qu'on obtient un verre au bore qui est incomplètement enlevé dans l'acide fluorhydrique tamponné mais qui est enlevé sans résidu par un traitement dans l'acide fluorhydrique, dans l'acide nitrique chaud et enfin de nouveau dans l'acide fluorhydrique.

3. Procédé selon la revendication 2, caractérisé en ce que les corps de silicium sont immergés pendant 10 secondes dans de l'acide fluorhydrique dilué avec de l'eau dans une proportion 1:10, ensuite pendant 10 minutes dans de l'acide nitrique concentré chauffé à une température de 95°C et ensuite pendant 30 secondes dans de l'acide fluorhydrique (1:10).

4. Procédé selon l'une quelconque ou plusieurs des revendications 1 à 3, caractérisé en ce que l'on utilise du bromure de bore (BBr₃) comme source de bore et les corps de silicium sont exposés à un mélange généré à la température de diffusion du BBr₃ et de O₂, et contenu dans un flux de gas porteur.

5. Procédé selon l'une quelconque ou plusieurs des revendications 1 à 4, caractérisé en ce que le premier procédé thermique est basé sur un diamètre intérieur du tube de réaction d'environ 8 cm et sur un flux de gaz porteur compris entre 2 et 5 litres/minute et sur un flux de gaz de stabilisation compris entre 0,5 et 1 litre/minute et en ce qu'on ajoute au gaz porteur durant le dépôt des quantités de BBr₃ comprises entre environ 15 et 30 milligrammes/minute, et au moins durant le dépôt une quantité d'oxygène concordant avec la quantité de BBr₃ de telle sorte que le rapport molaire O₂:BBr₃ soit compris entre environ 20 et environ 65.

6. Procédé selon l'une quelconque ou plusieurs des revendications 1 à 5, caractérisé en ce que durant le premier procédé thermique on place les corps de silicium sous forme de tranches (13) dans une nacelle (12) perpendiculairement par rapport au flux de gaz dans une zone de réaction ayant un profil de température plat; dans cette dernière on fait passer le mélange de gaz venant d'une chambre de mélange (9) à travers une plaque perforée (10) qui occupe approximativement le diamètre du tube, et qui, est limitée par ladite plaque perforée 10) et par une chicane (11) composée de deux tranches de quartz reliées entre-elles et occupant approximativement le diamètre du tube et disposées perpendiculairement à l'axe du tube; le mélange de gaz étant drainé par un tube de drainage (8) entre les tranches de quartz de la chicane (11); et, le gaz de stabilisation étant introduit par un tube d'amenée (7) entre la chicane (11) et l'extrémité du tube (2) fermé par un capot (3).

7. Procédé selon l'une quelconque ou plusieurs des revendications 1 à 6, caractérisé en ce que lorsqu'aucune charge (lot de tranches) ne se trouve dans le tube de réaction ou lorsqu'il n'y a pas de pré-dopage, la zone de réaction dans le four pour le premier procédé thermique est constamment maintenue à la température de dépôt et le tube est balayé par de l'oxygène, et en ce que lorsque durant un temps prédéterminé aucune charge n'a été traitée dans le tube de réaction ou lorsque le tube de réaction vient d'être nettoyé, le tube de réaction est prédopé à la température de dépôt par l'introduction du mélange de gaz de dépôt, et ceci pendant un temps prédéterminé avant une nouvelle utilisation.

8. Procédé selon l'une quelconque ou plusieurs des revendications 1 à 7, caractérisé en ce qu'on nettoie le tube de réaction pour le premier procédé thermique en enlevant le verre de bore lorsque les valeurs de résistance de surface obtenues et reportées dans les mêmes conditions pour des charges successives, commencent à augmenter ou à diminuer.

9. Procédé selon l'une quelconque ou plusieurs des revendications 1 à 8, caractérisé en ce que le premier procédé thermique utilise une température comprise entre environ 850 et 950 °C et en ce que le second procédé thermique est effectué dans une atmosphère oxydante.

10. Procédé selon la revendication 9, caractérisé en ce qu'on fait passer sur les tranches de silicium placées dans un tube de réaction d'un diamètre intérieur d'environ 8 cm à une température de 875 ± 1 °C d'abord pendant 15 minutes un mélange de gaz composé de 3,2 litres d'argon par minute et de 0,08 litre d'oxygène/minute, ensuite pendant 20 minutes ce même mélange de gaz additionné d'argon soit 0,08 litre d'argon/minute qui a été auparavant saturé avec du $BBr_3$ à une température de 5 °C, et enfin pendant encore 15 minutes le mélange de gaz utilisé au début; en ce qu'on enlève après le refroidissement la couche de verre de bore et en ce qu'on fait enfin passer sur les tranches de silicium à une température de 925 ± 1 °C pendant 10 minutes 1,5 litres d'oxygène/minute et ensuite pendant 51 minutes de la vapeur d'eau et enfin pendant 10 minutes encore une fois 1,5 litres d'oxygène/minute.

11. Procédé selon l'une quelconque ou plusieurs des revendications 1 à 8, caractérisé en ce que durant le premier procédé thermique la quantité de bore nécessaire pour l'étalement est pratiquement insérée dans la couche de $SiB_6$ à des températures comprises entre environ 950 et 1000 °C en appliquant le moins d'oxygène possible et en ce qu'on utilise une atmosphère de gaz inerte pour le second procédé thermique.

12. Procédé selon la revendication 1, caractérisé en ce qu'on chauffe les corps de silicium dans une atmosphère d'argon pendant environ 22 minutes d'environ 900 °C à 970 °C, et on les expose ensuite pendant 4 minutes à 970 °C à un flux de mélange de gaz de 3,6 litres d'argon/ minute, de 0,1 litre d'oxygène par minute et de 0,1 litre d'argon par minute saturé auparavant avec du $BBr_3$ à une température de +5 °C, et ensuite pendant 5 minutes à un flux d'argon de 1,5 litres/ minute et on les refroidit ensuite pendant 20 minutes dans une atmosphère d'argon de 970 °C à environ 900 °C; et en ce qu'on enlève le verre de bore complètement après la sortie du four et traite enfin les tranches de silicium pendant 80 minutes à une température de 1000 °C dans une atmosphère d'azote ou d'argon.

# FIG. 1

FIG. 2

0 008 642

MOL-VERHÄLTNIS
$O_2 : BBr_3$

16,8

24,4

31,5

42,0
50,4

FIG.4A

FIG.4B

FIG.4C

FIG.4D

FIG.4E

19

FIG. 3